# EUROPÄISCHE PATENTSCHRIFT

(11) **EP 2 260 438 B1**
(45) Veröffentlichungstag und Bekanntmachung des Hinweises auf die Patenterteilung: **13.05.2015**
(21) Anmeldenummer: 09725724.0
(22) Anmeldetag: 20.03.2009
(51) Int. Cl.: G06K 19/077, H01L 23/498

(54) **Transpondermodul**
Transponder module
Module transpondeur

(30) Priorität: 28.03.2008 DE 102008016274
(43) Veröffentlichungstag der Anmeldung: 15.12.2010
(73) Patentinhaber: Smartrac IP B.V., 1077 XX Amsterdam (NL)
(72) Erfinder: RIETZLER, Manfred, 87616 Marktoberdorf (DE); FREEMAN, Raymond, Mesa, AZ 85213 (US)
(74) Vertreter: Böck, Bernhard
(86) Internationale Anmeldenummer: PCT/EP2009/002088
(87) Internationale Veröffentlichungsnummer: WO 2009/118136

(56) Entgegenhaltungen:
- EP-A- 1 628 244
- DE-A1- 19 640 304
- DE-A1- 19 703 990
- DE-A1- 19 745 648
- DE-A1- 19 958 328
- US-A1- 2006 243 812

## Beschreibung

Die vorliegende Erfindung betrifft ein Transpondermodul mit einem auf einem Antennenmodul angeordneten Chipmodul nach dem Oberbegriff des Anspruchs 1.

Transpondermodule, die ein Antennenmodul sowie ein mit dem Antennenmodul kontaktiertes Chipmodul aufweisen, sind hinreichend bekannt und werden in unterschiedlichen Ausführungsformen zu Erkennungsoder Authentisierungszwecken eingesetzt. In einer häufig anzutreffenden Ausführungsform weisen Transpondermodule ein Antennenmodul auf, das mit einer auf einem Antennensubstrat aufgebrachten Antenne versehen ist, die mehrere Windungen auf dem Antennensubstrat ausbildet und über an den Windungsenden vorgesehene Kontaktflächen mit dem Chipmodul verbunden ist. Derartige Transpondermodule ermöglichen über die Antenne einen kontaktlosen Zugriff auf den Chip, so dass beispielsweise auf dem Chip gespeicherte Identifikationsdaten mit einer geeigneten Leseeinrichtung ausgelesen werden können.

Werden derartige Transpondermodule zur Herstellung von Klebeetiketten oder Gepäckanhängern oder dergleichen verwendet, wird ein derartiges Transpondermodul auf beiden Seiten mit Decklagen versehen, die gegebenenfalls als Trägerfläche für den Auftrag eines adhäsiven Haftmittels oder einer Bedruckung dienen. Trotz dieses regelmäßig sehr dünnen Lagenaufbaus muss natürlich gewährleistet sein, dass der gegenüber mechanischen Beanspruchungen sehr empfindliche Chip ausreichend geschützt wird. Hierzu ist es bekannt, den Chip mit einem geeigneten Gehäuse zu versehen. Nachteilig an diesem Gehäuse ist jedoch, dass das Gehäuse zur Ausbildung einer sich leicht an der äußeren Oberfläche abzeichnenden lokalen Verdickung führt. Hierdurch wird eine nachträgliche Bedruckung des Lagenaufbaus des Transpondermoduls erschwert sowie die Ausbildung einer auf der gesamten Oberfläche gleichmäßig haftenden Kleberverbindung beeinträchtigt.

Die DE 197 03 990 A1 zeigt ein als Chipkarte ausgebildetes Transpondermodul mit einem Chipmodul, das einen Chipträger aufweist, der über Antennenkontaktflächen mit Kontaktflächen einer in einem monolithischen Kartenkörper ausgebildeten Antenne kontaktiert ist. In den Kartenkörper ist zur Aufnahme des Chipmoduls eine Aussparung eingebracht, derart, dass über ein Materialabtragsverfahren die Aussparung für das Chipmodul erzeugt wird sowie die vorgenannten Kontaktflächen der Antenne zur Kontaktierung mit den Antennenkontaktflächen des Chipmoduls freigelegt werden.

Aufgabe der vorliegenden Erfindung ist es, ein Transpondermodul zu ermöglichen, das eine sichere, gegen mechanische Beanspruchungen geschützte Anordnung des Chips im Transpondermodul ermöglicht und das zur Erhöhung der Dicke des ein Antennensubstrat und ein Chipsubstrat umfassenden Lagenaufbaus des Transpondermoduls möglichst wenig beiträgt.

Zur Lösung dieser Aufgabe weist das erfindungsgemäße Transpondermodul die Merkmale des Anspruchs 1 auf.

Das erfindungsgemäße Transpondermodul weist einen Chipträger auf mit einem streifenförmigen Trägersubstrat, das mit einer von Längsenden des Trägersubstrats beabstandeten Chipkontaktanordnung zur elektrischen Kontaktierung mit einem Chip und zwei die Chipkontaktanordnung zwischen sich aufnehmenden Antennenkontaktflächen zur elektrischen Kontaktierung mit der Antenne versehen ist. Darüber hinaus ist bei dem erfindungsgemäßen Chipträger zwischen der Chipkontaktanordnung und den Antennenkontaktanordnungen zumindest eine Isolationsfläche ausgebildet. Die Chipkontaktanordnung, die Antennenkontaktflächen und die Isolationsfläche befinden sich bei dem erfindungsgemäßen Chipträger auf derselben Applikationsoberfläche.

Erfindungsgemäß erstrecken sich die Kontaktflächen der auf dem Antennensubstrat angeordneten Antenne zumindest anteilig über im Antennensubstrat ausgebildete Kontaktausnehmungen. Das Chipmodul ist erfindungsgemäß auf der der Antennenseite gegenüber liegenden Gegenseite des Antennensubstrats derart angeordnet, dass die Antennenkontaktflächen mit den Kontaktflächenrückseiten der Antenne elektrisch leitend kontaktiert sind.

Hierdurch wird eine Kontaktierung zwischen den Kontaktflächen der Antenne und den Antennenkontaktanordnungen des Chipmoduls ermöglicht, ohne dass auf der Gegenseite des Antennensubstrats Kontaktflächen ausgebildet sein müssten.

Eine besonders dünne Ausbildung des Transpondermoduls wird möglich, wenn der Chip erfindungsgemäß in eine im Antennensubstrat ausgebildete Fensteröffnung als Chipausnehmung eingreift.

Bei einer Variante des Transpondermoduls kann die Ausnehmung im Antennensubstrat auch als Chipmodulausnehmung ausgebildet sein, bei der die Chipausnehmung und die Kontaktausnehmungen zusammenhängend ausgebildet sind und das gesamte Chipmodul aufnehmen.

Besonders vorteilhaft ist es auch, wenn sowohl das Antennensubstrat als auch das Trägersubstrat aus einem Polyolefin bestehen, da somit zum einen eine besonders gute Anschmiegung zwischen dem Trägersubstrat und dem Antennensubstrat ermöglicht wird, und zum anderen aufgrund der Materialauswahl eine Lamination zur Erzielung eines besonders fest gefügten Gesamtaufbaus des Transpondermoduls leicht durchführbar ist.

In diesem Zusammenhang erweist es sich auch als vorteilhaft, wenn das Antennensubstrat und das Trägersubstrat des Chipmoduls aus demselben Material, beispielsweise PET, bestehen.

Nachfolgend wird eine bevorzugte Ausführungsform der Erfindung anhand der Zeichnungen näher erläutert.

Es zeigen:
- **Fig. 1**: ein Chipmodul mit einem auf einem Chipträger angeordneten Chip in Draufsicht;
- **Fig. 2**: das in **Fig. 1** dargestellte Chipmodul in Seitenansicht;
- **Fig. 3**: einen Folienträger mit einer Mehrzahl in Längsreihen angeordneter Chipträger;
- **Fig. 4**: eine Ausführungsform eines Transpondermoduls;
- **Fig. 5**: eine weitere Ausführungsform eines Transpondermoduls.

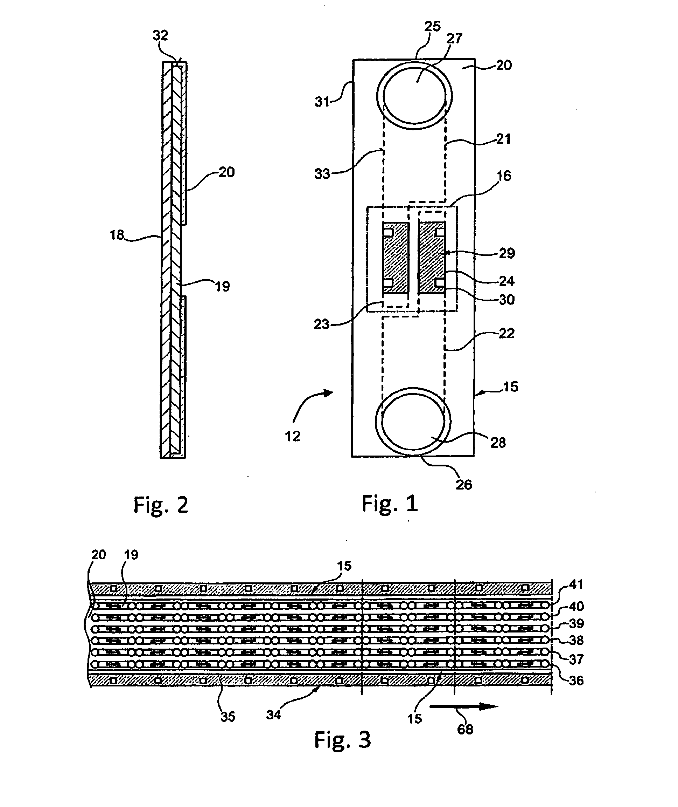

**Fig. 1** zeigt ein Chipmodul 12 in Draufsicht, wobei zur besseren Darstellung des Chipträgers 15 der Chip 16 nur in seinen Umrisslinien angedeutet ist.

Wie sich aus einer Zusammenschau der **Fig. 1** und **Fig. 2** ergibt, ist der Chipträger 15 im Wesentlichen dreilagig aufgebaut mit einem Trägersubstrat 18, das im vorliegenden Fall aus PET ausgebildet ist, einer auf das Trägersubstrat 18 aufgebrachten, hier vorzugsweise aus Aluminium bestehenden Kontaktmetallisierung 19 und einer Isolationsschicht 20, die auf der Kontaktmetallisierung 19 angeordnet ist.

Wie insbesondere der **Fig. 1** zu entnehmen ist, ist die Kontaktmetallisierung 19 zweiteilig ausgebildet mit einer ersten Kontaktmetallisierungsteilfläche 21 und einer zweiten Kontaktmetallisierungsteilfläche 22, die jeweils einen Kontaktflächenausleger 23 bzw. 24 aufweisen. Im Bereich der sich parallel zueinander erstreckenden Kontaktflächenausleger 23, 24 und an Längsenden 25, 26 des Trägersubstrats 18 weist die Isolationsschicht 20 Kontaktausnehmungen auf, die an den Längsenden 25, 26 jeweils eine Antennenkontaktfläche 27 bzw. 28 und im Bereich der Kontaktflächenausleger 23, 24 eine Chipkontaktanordnung 29 ausbilden.

Wie aus der Darstellung der Chipkontaktanordnung 29 in **Fig. 1** hervorgeht, ist diese im dargestellten Ausführungsbeispiel mit erhöhten Kontaktpunkten, so genannten "Bumps" 30, versehen, die eine Kontaktierung mit dem hier nur andeutungsweise dargestellten Chip 16 im so genannten "Flip-Chip-Verfahren" ermöglichen.

Wie weiter aus einer Zusammenschau der **Fig. 1** und **Fig. 2** zu entnehmen ist, ist die wie das Trägersubstrat 18 streifenförmig ausgebildete Kontaktmetallisierung 19 insgesamt flächenmäßig kleiner bemessen als eine Applikationsoberfläche 31 des Trägersubstrats 18, mit der Folge, dass die Isolationsschicht 20 mit Ausnahme der Antennenkontaktflächen 27, 28 und der Chipkontaktanordnung 29 nicht nur die Kontaktmetallisierung 19 abdeckt, sondern auch Längs- und Querränder 32, 33 der Applikationsfläche 31 sind durch die adhäsive Isolationsschicht 20 abgedeckt. Einerseits ergibt sich hierdurch eine mit Ausnahme der Chipkontaktanordnung 29 und der Antennenkontaktflächen 27, 28 vollständig isolierende Abdeckung der Kontaktmetallisierung 19. Andererseits ergibt sich eine geschlossene Umrahmung des Chipträgers 15 mit Klebermaterial. Bei dem in den **Fig. 1** und **Fig. 2** dargestellten Ausführungsbeispiel des Chipträgers 15 ist die Isolationsschicht 20 durch eine Auftragsschicht aus einem Klebermaterial gebildet, so dass der Isolationsschicht 20 im vorliegenden Fall eine Doppelfunktion zukommt, derart, dass sie neben der isolierenden Wirkung bei einer Applikation des Chipträgers 15 bzw. des mit dem Chipträger 15 versehenen Chipmoduls 12 auf dem Antennenmodul 11 eine mechanisch belastbare Kleberverbindung zum Antennensubstrat 54 bzw. zur Antenne 13 auf dem Antennensubstrat 54 herstellt.

**Fig. 3** zeigt die Ausbildung einer Mehrzahl von Chipträgern 15 auf einem Folienträger 34, der im vorliegenden Fall als Förderfolie mit Traktionsrändern 35 ausgebildet ist. Auf den Folienträger 34 unmittelbar aufgebracht befinden sich Kontaktmetallisierungen 19 in hier sechs parallel zueinander angeordneten, in Längsrichtung des Folienträgers 34 bzw. in Vorschubrichtung des Folienträgers 34 sich erstreckenden Reihenanordnungen 36, 37, 38, 39, 40 und 41. Die Gesamtheit der Reihenanordnungen 36 bis 41 ist durch eine Isolationsschicht 20 abgedeckt, wobei, wie vorstehend unter Bezugnahme auf die **Fig. 2** und **Fig. 3** beschrieben, die einzelnen Kontaktmetallisierungen 19 betreffend jeweils eine Chipkontaktanordnung 29 und zwei Antennenkontaktflächen 27, 28 ausgenommen sind.

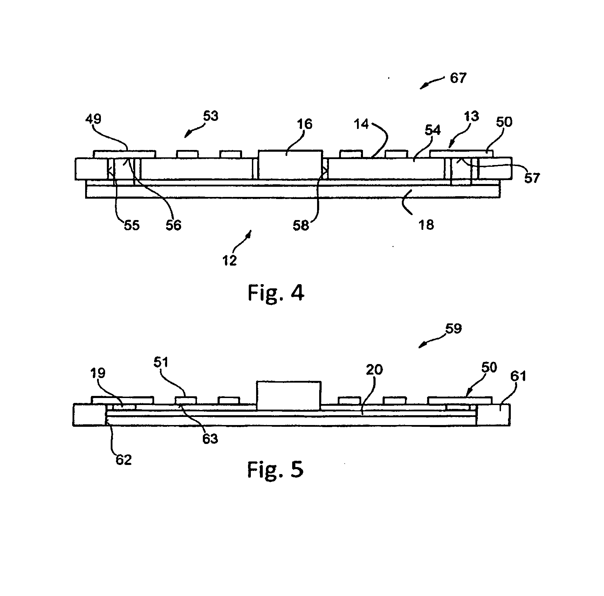

**Fig. 4** zeigt ein Transpondermodul 67 mit einer abweichenden Anordnung des Chipmoduls 12 auf einem Antennenmodul 53, dessen Antennensubstrat 54 mit Kontaktausnehmungen 55 versehen ist, die eine Kontaktierung der Kontaktflächen 49, 50 der Antenne 13 von den Kontaktflächenrückseiten 56, 57 ermöglichen. Wie die **Fig. 4** zeigt, ist im Antennensubstrat 54 darüber hinaus eine Chipausnehmung 58 (Fensteröffnung) vorgesehen, die eine Anordnung des Chips 16 innerhalb der Chipausnehmung 58 (Fensteröffnung) ermöglicht und damit eine insgesamt sehr flache bzw. dünne Ausbildung eines aus dem Antennenmodul 53 und dem Chipmodul 12 gebildeten Transpondermoduls 67.

**Fig. 5** zeigt ein Transpondermodul 59 mit einem Antennenmodul, dessen Antennensubstrat 61 eine Chipmodulausnehmung 62 aufweist, die eine insgesamt klebende Anordnung der Isolationsschicht 20 gegen Windungsrückseiten 63 der Antennenwindungen 51 ermöglicht. Hierdurch befindet sich die Isolationsschicht 20 bzw. die durch die Isolationsschicht 20 zumindest teilweise abgedeckte Kontaktmetallisierung 19 im Wesentlichen in einer Ebene mit dem Antennensubstrat 61.

## Patentansprüche

1. Transpondermodul (67) mit einem auf einem Antennenmodul (53) angeordneten Chipmodul (12) mit einem Chip (16) und einem mit einem streifenförmigen Trägersubstrat (18) aufgebauten Chipträger (15), wobei der Chip mit einer von Längsenden (25, 26) des Trägersubstrats beabstandeten, zwischen Antennenkontaktflächen (27, 28) angeordneten Chipkontaktanordnung (29) elektrisch kontaktiert ist, derart, dass die Chipanschlussflächen des Chips unmittelbar mit der Chipkontaktanordnung elektrisch leitend verbunden sind, wobei sich die Chipkontaktanordnung und die Antennenkontaktflächen auf einer Applikationsoberfläche (31) des Chipträgers befinden und zwischen der Chipkontaktanordnung und den Antennenkontaktflächen auf der Applikationsoberfläche zumindest eine Isolationsfläche (20) ausgebildet ist,
**dadurch gekennzeichnet,**
**dass** das Antennenmodul eine auf einer Antennenseite (14) eines Antennensubstrats (54) angeordnete Antenne (13) aufweist, deren Kontaktflächen (49, 50) sich zumindest anteilig über im Antennensubstrat ausgebildete Kontaktausnehmungen (55) erstrecken, wobei das Chipmodul auf einer der Antennenseite gegenüberliegenden Gegenseite des Antennensubstrats (54) derart angeordnet ist, dass die Antennenkontaktflächen des Chipmoduls mit Kontaktflächenrückseiten (56, 57) der Kontaktflächen elektrisch leitend kontaktiert sind und der Chip in eine im Antennensubstrat ausgebildete Fensteröffnung (58) eingreift.

2. Transpondermodul nach Anspruch 1,
**dadurch gekennzeichnet,**
**dass** die Chipausnehmung (58) und die Kontaktausnehmungen (55) als eine im Antennensubstrat (61) zusammenhängend ausgebildete Chipmodulausnehmung (62) ausgebildet sind.

3. Transpondermodul nach Anspruch 1 oder 2,
**dadurch gekennzeichnet,**
**dass** das Antennensubstrat (54, 61) und das Trägersubstrat (18) aus einem Polyolefin bestehen.

4. Transpondermodul nach Anspruch 3,
**dadurch gekennzeichnet,**
**dass** das Antennensubstrat (54, 61) und das Trägersubstrat (18) aus demselben Material, insbesondere PET, bestehen.

## Claims

1. A transponder module (67) comprising a chip module (12) disposed on an antenna module (53), with a chip (16) and a chip carrier (15) featuring a strip-shaped carrier substrate (18), the chip being electrically contacted with a chip contact arrangement (29) which is located at a distance from longitudinal ends (25, 26) of the carrier substrate and is disposed between antenna contact surfaces (27, 28), such that the terminal faces of the chip are directly connected to the chip contact arrangement in an electrically conductive manner, wherein the chip contact arrangement and the antenna contact surfaces are located on an application surface (31) of the chip carrier and at least one insulation surface (20) is formed on the application surface between the chip contact arrangement and the antenna contact surfaces,
**characterised in that**
the antenna module comprises an antenna (13) disposed on an antenna side (14) of an antenna substrate (54), the contact surfaces (49, 50) of the antenna at least partially extending over contact recesses (55) formed in the antenna substrate, wherein the chip module is disposed on an opposite side of the antenna substrate (54) facing the antenna side, such that the antenna contact surfaces of the chip module are contacted with contact surface back sides (56, 57) of the contact surfaces in an electrically conductive manner and the chip engages with a window opening (58) formed in the antenna substrate.

2. The transponder module according to claim 1,
**characterised in that**
the chip recess (58) and the contact recesses (55) are formed as a chip module recess (62) being coherently formed in the antenna substrate (61).

3. The transponder module according to claim 1 or 2,
**characterised in that**
the antenna substrate (54, 61) and the carrier substrate (18) are composed of a polyolefin.

4. The transponder module according to claim 3,
**characterised in that**
the antenna substrate (54, 61) and the carrier substrate (18) are composed of the same material, in particular PET.

## Revendications

1. Module (67) de transpondeur ayant un module (12) de puce étant disposé sur un module (53) d'antenne, ayant une puce (16) et un support (15) de puce étant construit avec un substrat porteur (18) en forme de bande, dans lequel la puce est mise en contact électriquement avec un agencement (29) de contact de puce étant espacé d'extrémités (25, 26) longitudinales du substrat porteur et étant disposé entre des surfaces (27, 28) de contact de l'antenne, tellement que les surfaces de raccordement de la puce sont directement connectées à l'agencement de contact de puce de façon électriquement conductrice, dans lequel l'agencement de contact de puce et les surfaces de contact de l'antenne se trouvent sur une surface (31) d'application du support de puce et dans lequel au moins une surface (20) d'isolation est formée sur la surface d'application entre l'agencement de contact de puce et les surfaces de contact de l'antenne,
**caractérisé en ce que**
le module d'antenne présente une antenne (13) qui est disposée sur un côté d'antenne (14) d'un substrat (54) d'antenne et dont les surfaces (49, 50) de contact s'étendent au moins en partie sur des évidements (55) de contact étant formés dans le substrat d'antenne, le module de puce étant disposé sur un côté opposé du substrat (54) d'antenne en face du côté d'antenne, tellement que les surfaces de contact de l'antenne du module de puce sont mises en contact avec des faces arrières (56, 57) des surfaces de contact de façon électriquement conductrice et que la puce s'engage dans une ouverture (58) de fenêtre étant formée dans le substrat d'antenne.

2. Module de transpondeur selon la revendication 1,
**caractérisé en ce que**
l'évidement (58) de puce et les évidements (55) de contact sont formés en tant qu'évidement (62) de module de puce étant formé de façon cohérente dans le substrat (61) d'antenne.

3. Module de transpondeur selon la revendication 1 ou 2,
**caractérisé en ce que**
le substrat (54, 61) d'antenne et le substrat porteur (18) se composent d'une polyoléfine.

4. Module de transpondeur selon la revendication 3,
**caractérisé en ce que**
le substrat (54, 61) d'antenne et le substrat porteur (18) se composent du même matériau, en particulier du PET.
